# EUROPEAN PATENT SPECIFICATION

(11) **EP 0 728 850 B1**
(45) Date of publication and mention of the grant of the patent: **17.05.2000**
(21) Application number: 96102721.6
(22) Date of filing: 23.02.1996
(51) Int. Cl.: C23C 16/46, C23C 16/48, H01L 21/00

(54) **Quasi hot wall reaction chamber**
Reaktionskammer mit quasi heisser Wandung
Chambre de réaction à parois quasi chaudes

(30) Priority: 23.02.1995 US 394317; 25.08.1995 US 520233
(43) Date of publication of application: 28.08.1996
(73) Proprietor: APPLIED MATERIALS, INC., Santa Clara, California 95052-8039 (US)
(72) Inventor: Lindstrom, Paul R., Santa Cruz, California 95060 (US)
(74) Representative: Kahler, Kurt, Dipl.-Ing.

(56) References cited:
- EP-A- 0 445 596
- EP-A- 0 476 307
- WO-A-94/17353
- US-A- 5 372 648
- PATENT ABSTRACTS OF JAPAN vol. 008, no. 281 (E-286), 21 December 1984 & JP 59 149020 A (HITACHI SEISAKUSHO KK), 25 August 1984,

## Description

### Background of the Invention

This invention relates, in general, to chemical vapor deposition (CVD) processing chambers, and, more particularly, to a processing chamber that provides a nearly isothermal environment for a substrate being processed while keeping the chamber walls cooler than the substrate. The present invention is particularly suitable for use in depositing polysilicon onto substrates.

Chemical Vapor Deposition (CVD) reactors are utilized to deposit a wide variety of materials in many integrated circuit manufacturing processes. In general, the temperature of the gases in the reactor chamber and/or the temperature of the wafer are regulated to optimize the deposition step being performed within such chamber. The optimal temperature is very dependent on the deposition process and the desired properties of the layer being deposited. However, in general, it is advantageous to produce a uniform rate of deposition over the entire surface of the wafer so that the thickness of the resulting layer will be uniform over the entire wafer surface. When the thicknesses of layers vary over the surface of the wafer, the electrical properties of the resulting integrated circuit also vary over the wafer surface. Also, in some process steps such as etch steps, if a layer varies in thickness, then, when this layer is etched sufficiently long to etch through the thickest portions of this layer, the thinner regions will be overprocessed. Such local overprocessing will generally result in spatial variations of the line widths, thereby further contributing to the variable operation of circuits at different locations on the wafer. Thus, it is important to produce a substantially uniform temperature across the entire wafer so that the process rates of the various process steps are uniform across the entire wafer.

Small line width integrated circuits are particularly strongly affected by spatial variations of rates of processing of wafers during integrated circuit fabrication. For given variations of process rates, such as the rates of deposition and etch steps, the fractional effect on resulting line widths and other circuit dimensional parameters is inversely proportional to the line width. Small amounts of process rate variation can have a large impact on the yield of small line width integrated circuit fabrication processes. Therefore, in state-of-the-art integrated circuit fabrication equipment, it is particularly important to minimize process variations across the wafer.

There are two broad categories of CVD reactors: hot wall reactors and cold wall reactors. In a hot wall reactor, the walls of the processing chamber are heated by some means, such as heater coils located in close proximity to these walls. In such systems, the walls are the hottest part of the reactor and heat is transmitted to the wafer by conduction and radiation from these hot walls. In general, there is a flow rate of reactants across the wafer so that heat is also transmitted to the wafer by the convective flow of gases.

Chemical reaction rates are temperature dependent and, in the case of many reactions utilized in integrated circuit processing, the reaction rates vary rapidly with temperature. Because the reactor walls are the hottest portions of the processing chamber, a significant rate of deposition occurs on the walls during a deposition process. The resulting coating on the walls can flake off onto the wafer and produce defects that can make circuits defective or even inoperative. Because many integrated circuit processes require that the temperature vary with time within a given processing chamber, such cycling of the temperature can contribute strongly to the rate at which portions of the coatings on the wall flake off onto the wafer.

Cold wall reactors exhibit a significantly reduced amount of deposition on the walls by keeping the temperature of the walls well below the temperature of the wafer. In one form of heating the wafer (see, for example, **U.S. Patent 4,654,509** entitled *Method and Apparatus for Substrate Heating in an Axially Symmetric Epitaxial Deposition Apparatus* issued to Robinson, et al., on March 31, 1987) during processing of the wafer within the reactor the wafer is placed on a susceptor that is heated by a high intensity flux of light from an array of lamps positioned partially within the chamber. In order to heat the susceptor, the wavelength of the light and the material for the susceptor are selected so that the susceptor is opaque to this light. In a similar type of system presented in **U.S. patent 4,728,389**, entitled *Particulate-free Epitaxial Process*, issued to Roger E. Logar on March 1, 1988, the susceptor is heated by light from an array of lamps positioned outside the reactor chamber. To avoid heating the walls with this light, the walls are of a material that is transparent to this light. Because the hot gases within the processing chamber heat the walls of the chamber, to further enhance the temperature difference between the walls and the wafer, these cold wall systems also actively cool the walls by blowing cool air against the outside surfaces of these walls. Typical temperature values for the wafer and walls in such cold wall systems are 1200 degrees centigrade and 600 degrees centigrade, respectively.

Unfortunately, in systems in which the susceptor is heated by light from an array of lamps, the light intensity at the surface between the susceptor and the wafer is not uniform in intensity. This produces a spatial variation in the temperature of the susceptor, thereby producing a spatial variation in the temperature of the wafer. Even the small variations in the radiant flux from an array of light sources is sufficient to affect the process uniformity at the wafer. It would, therefore, be advantageous for the reactor to produce a more uniform temperature profile in the wafer than is produced by reactors in which the wafer is heated only by a susceptor with which it is in direct contact.

Another disadvantage of reactors in which the wafer is heated only by a susceptor in direct contact with the wafer is that the rate of change of temperature of the wafer is slow because of the high heat capacity of the susceptor. Although this high heat capacity is advantageous in smoothing out unwanted rapid temporal fluctuations in temperature of the wafer, the slow rate of temperature change increases process time. It would, therefore, be advantageous to have a reactor that not only produces a more uniform spatial distribution of temperature of the wafer, but that also can change the temperature of the top surface of the wafer at a faster rate than systems utilizing only a susceptor to heat the wafer.

In EP-A-0 476 307 and in EP-A-0 445 596 a CVD apparatus is disclosed for substrate heating in semiconductor processes comprising two heater apparatusses comprising arrays of heater lamps arranged in a circle concenmtric with the wafer substrate to be heated which is placed on a susceptor. The susceptor is enclosed in a chamber formed by two domed covers made of transparent material. However, in EP-A-0 476 307 the heat sources are the lamps.

### Summary of the Invention

A new chemical vapor deposition processing chamber structure according to claims 1 and 11, respectively is presented that provides an increased level of temperature uniformity of a semiconductor wafer substrate being processed within the subject chamber. The wafer is supported on a susceptor that provides heat to a bottom surface of the wafer. Closely spaced from a top surface of the wafer is a disk-shaped thermal source that provides to a top surface of the wafer a flux of energy of increased uniformity. The thermal flux from both the susceptor and the disk-shaped thermal source produce a much more uniform temperature at the top surface of the wafer than if the wafer were heated only by the susceptor. The small gap between the disk and the wafer enables each point of the wafer to receive a flux of energy that is proportional to an average over the temperature distribution of the bottom surface of the opaque disk. For any given point of the top surface of the wafer, the weighting function for this averaging process is the solid angle subtended by each region of the opaque disk bottom surface. This causes the energy flux from the bottom surface of the thermal source to the top surface of the wafer to be even more uniform than the temperature distribution in the bottom surface of this disk.

In one embodiment according to claim 1, the thermal source consists of an opaque disk and a high energy light source that heats this disk to a preselected temperature. The opaque disk is located within the processing chamber closely spaced above the wafer. The light source is external to the processing chamber and a top wall of the chamber enables light from this source to be directed onto the opaque disk.

This opaque disk functions as a "thermal flywheel" to produce a uniform temperature of the wafer even when the flux of light directed toward the wafer is not uniform. Just as a conventional flywheel smooths out the speed of rotation of a system with rotating parts, this thermal flywheel smooths out the temperature distribution in the wafer. To avoid significantly coating the opaque disk during a process run, it is important that the temperature of the opaque disk be enough below the temperature of the wafer that the rate of deposition onto the opaque disk is much less than the rate of deposition onto the wafer. Because of the substantially exponential dependence of reaction rates on the inverse of the temperature, the opaque disk need only be about 50-150 degrees centigrade below the temperature of the wafer to achieve this difference in deposition rates.

The opaque disk is positioned parallel and coaxial with the wafer and is closely spaced from the wafer so that the disk will efficiently transfer energy to the wafer. A convenient source for the high intensity light beam is an array of light sources distributed to provide a fairly uniform intensity of light at the opaque disk. However, because this light intensity distribution at the surface of the disk on which the light is incident (referred to herein as the "top surface of the opaque disk") has a spatially variable component, the resulting temperature distribution on this front surface will exhibit the same spatial pattern in its temperature distribution. However, the disk has sufficient thickness that the fractional spatial variation of the temperature distribution on an opposite surface of the disk (referred to herein as the "back surface of the opaque disk") is significantly reduced in magnitude compared to the fractional spatial variation on the front surface.

The diameter of the opaque disk should be large enough so that the points near the perimeter of the disk will receive energy from points on the disk over substantially the same solid angle as points near the center of the wafer so that the flux of energy to these points near the perimeter of the disk will be substantially the same as to those points near the center of the disk. To achieve this energy distribution, the diameter of the disk must be equal to or greater than the wafer being processed. Therefore, the diameter of the opaque disk is larger than that of the wafer and can extend to a dimension substantially equal to the diameter of the processing chamber.

The disk is either opaque to the light incident on the disk or else has a surface (preferably the top surface) covered with an opaque coating. The disk and any coating are selected to remain substantially chemically intact under the chemical, physical and temperature conditions that will be experienced within the reaction chamber. It is advantageous for the disk material to have a high thermal conductivity so that the energy that is incident on the top surface will be effectively transmitted to the bottom surface. In addition, this high conductivity will reduce the spatial variation in temperature on the bottom surface of the opaque disk.

Because the wafer transmits energy toward the walls as well as toward the wafer, the presence of the thermal flywheel in the chamber will produce a higher temperature of the chamber walls than will a similar chamber that differs only by the omission of this thermal flywheel. In addition, for many wafer fabrication processes that can be carried out within this chamber, it is not necessary that the walls be kept substantially at room temperature. Therefore, for such processes, no cooling mechanism is included to cool the walls to near room temperature. This will reduce the cost of the reactor as well as reduce the costs otherwise required to cool the reactor walls. Because this will make the walls somewhat warmer than in the conventional cold-wall-type reactors, this type of reactor will be referred to herein as a "warm wall reactor."

In another embodiment according to claim 11 of this reactor, the thermal source is a relatively thin top wall of the processing chamber, which wall houses heater and cooling assemblies, the latter comprised of a metallic plate having fluid cooling coils embedded or coplanarly affixed to a surface thereof. The manipulation of the heat source assembly with the cooling assembly produces in this thin-top wall a substantially uniform temperature that can be quickly altered by further adjustment of the cooling assembly. The thin top wall of this embodiment is generally planar and spaced closely from the wafer so that this wall can produce a uniform flux of energy onto the wafer. To enable this wall to be thin enough to produce a large and uniform flux of energy onto the wafer, a vacuum is produced above the wall to substantially reduce the pressure difference across the wall.

### Description of the Figures

Figure 1 illustrates a reactor containing a disk element as a thermal flywheel source to distribute incident energy with improved uniformity onto a wafer being processed within the reactor.

Figure 2 illustrates a reactor containing a thermal source containing heating and cooling assemblies to transfer a uniform flux of energy to a wafer being processed within the reactor.

### Description of Preferred Embodiments

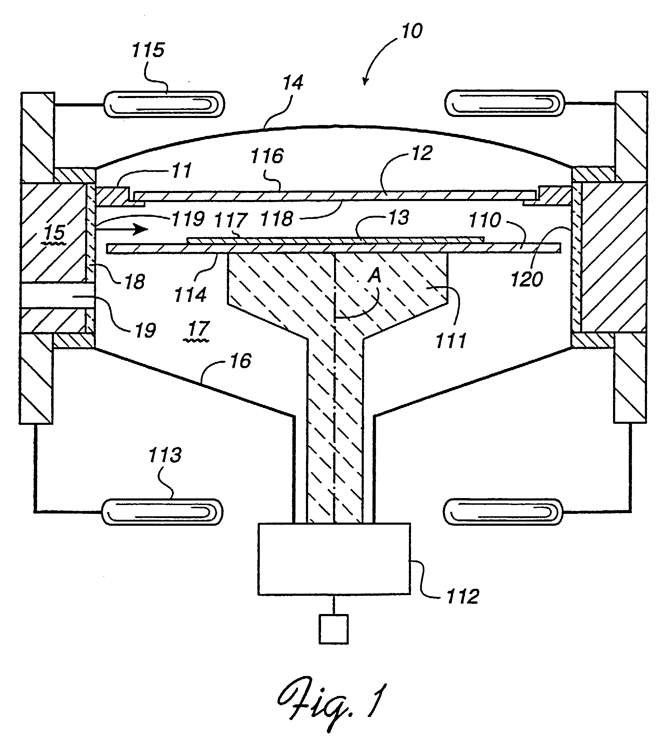

Figure 1 illustrates a reactor 10 containing an opaque disk 12 that functions as a thermal source of energy to a top surface of a wafer being processed within the reactor. As shown, disk 12 is larger than the diameter of wafer 13 and is supported on a circular donut 11. In particular, this opaque disk functions as a thermal flywheel to distribute incident energy with improved uniformity onto a wafer 13 being processed within the reactor. This reactor includes a quartz top wall 14, a stainless steel side wall 15 and a bottom wall 16 that enclose a processing chamber 17 within which a wafer 13 is placed for processing. A quartz liner 18 prevents gases in the processing chamber from reacting with the metallic side wall. A wafer transfer port 19 in sidewall 15 enables wafers to be transferred into and out of processing chamber 17.

Within the processing chamber, the wafer is supported on a susceptor 110 which, in turn, is supported by a pedestal 111. This pedestal is rotated by a motor 112 around a rotation axis A to produce a time-averaged rotationally symmetric process environment for the wafer. During processing, the circular wafer is positioned with its axis of rotational symmetry substantially collinear with symmetry axis A. In this embodiment, walls 14-16 are each rotationally symmetric about axis A.

A first array of twenty lamps 113 are positioned in a circular pattern at angular spacing of π/10 so that they produce, at a bottom surface 114 of susceptor 110, a flux of light that has a 20-fold rotational symmetry. These lamps are tungsten-halogen cycle lamps that produce a peak intensity at a wavelength near 0.9 µm (micron), which is within the infrared spectral region. Pedestal 111 is of a material, such as quartz, that is transparent to light from lamps 113 so that light from these lamps will pass through bottom wall 16 and the susceptor to elevate the temperature of the susceptor.

Each lamp includes a reflector that is oriented to increase the amount of light that is directed from these lamps onto the susceptor and to control the distribution of light onto the susceptor. Because the outer perimeter of the susceptor is closer to the cooler side wall 15 of the reactor, this portion of the susceptor will tend to be cooler than the portion of the susceptor near the axis A of rotational symmetry. To compensate for this, the shapes and locations of the reflectors are selected to direct a sufficiently greater flux of light near the susceptor perimeter that the radial distribution of temperature in susceptor bottom surface 114 is substantially uniform spatially. However, because there is some spatial variation of this flux, the susceptor will produce some spatial temperature variation at the top surface 117 of the wafer.

Quartz is a particularly useful choice for walls 14 and 16 and pedestal 111 because it has a number of desirable physical properties. It is highly transparent to light of the wavelength of these light sources so that it exhibits negligible direct heating by the light from these sources. It is mechanically strong so that a wall thickness of only 3-6 mm is sufficient to withstand up to an approximately 1 atmosphere pressure difference that is experienced during most integrated circuit process steps to be carried out within this processing chamber. It has a low porosity so that there is very little out gassing when the physical conditions within the processing chamber (e.g., pressure, temperature and/or gas composition) change. It also is substantially chemically inert to processes carried out within the processing chamber.

A second array of lamps 115 are positioned in a circular pattern at angular spacing of π/10 so that they produce, at the top surface 116 of opaque disk 12, a flux of light that also has a 20-fold rotational symmetry. These lamps are also tungsten-halogen cycle lamps that produce a peak intensity near 0.9 µm (micron) wavelength within the infrared spectral region. These lamps also include reflectors that are directed such that a radial distribution of the flux of light from lamps 115 compensates for the edge cooling of this opaque disk and the wafer. This temperature distribution will have a temperature about a hundred degrees centigrade lower at the perimeter of the disk than at he center of the disk. This distribution will also have a peak temperature, just inside of the perimeter of the disk, that is about 10-30 degrees above the temperature at the center of the disk.

The susceptor is elevated to a temperature that is dependent on the process within the chamber and on the reactants introduced into the chamber. For example, for deposition of polysilicon, the temperature of the susceptor is: 1100-1200 degrees centigrade for SiCl₄; 1050-1150 degrees centigrade for SiHCl₃; 900 - 1000 degrees centigrade for SiH₂Cl₂; and 550-1050 degrees centigrade for SiH₄. This reactor is particularly advantageous for the deposition of polysilicon because of the strong temperature dependence of the rate of deposition of polysilicon. Because the deposition rate is exponentially dependent on the inverse of the temperature, a temperature difference between the wafer and the opaque disk of less than 150 centigrade degrees can be sufficient to achieve the necessary low rate of deposition of polysilicon onto the opaque disk compared to the rate of deposition onto the wafer.

The light flux from lamps 115 must not elevate the temperature of the opaque disk above some upper threshold temperature **T**ᵤ at which a sufficient amount of coating on the opaque disk occurs in a single process run that a significant amount of particles deposit onto the wafer from this coating. However, since it is advantageous to have the temperature as high as possible without producing a significant amount of particles or adversely affecting throughput, the flux will be selected to produce a disk temperature for which the disk need be cleaned only every several runs (e.g., every 5th to 10th run). Such cleaning can be achieved in a cleaning cycle in which the opaque disk is elevated to a temperature on the order of 1,200 degrees centigrade, hydrochloric acid vapor at a pressure of 133 hPa (100 torr) is introduced for about 2-4 minutes, and then the processing chamber is flushed with a carrier gas such as H₂ or N₂ for about 30 seconds at a rate of about 10 liters per minute.

Because the light from lamps 115 has some small spatial variation in light intensity at the top surface 116 of the opaque disk, there will be a small spatial variation of temperature at this top surface. The thickness of opaque disk 12 is thick enough (on the order of 0.762-1.588 mm (0.030-0.25 inches)) that the temperature distribution on a bottom surface 118 of this opaque disk exhibits a reduced spatial distribution of temperature.

The gap between this bottom surface 118 and the top surface 117 of the wafer is preferably as small as possible to produce a good thermal transfer between this opaque disk and the wafer. In this reactor, reactant gases are supplied from a gas input port 119 and flow across the wafer to an exhaust port 120. In order to avoid interfering with the flux of reactants across the wafer, this gap is on the order of 1.27-2.54 cm (0.5-1 inch). This flow of gas across the wafer in combination with the rotation of the wafer around axis A further contributes to smoothing out the temperature profile in the top surface of the wafer.

At each point of the wafer top surface 117, the flux of energy received from each region of the bottom surface is proportional to the solid angle subtended at this point of the wafer by this region of the bottom surface. Because the wafer and opaque disk are substantially parallel, to produce a substantially constant flux of energy from the bottom surface of the opaque disk to each point of the wafer top surface, the opaque disk should have a significantly larger diameter than the wafer. Therefore, the diameter of the opaque disk is substantially equal to the diameter of the inner surface of the cylindrical side wall 15. In an embodiment for processing 20,32 cm (8-inch)-diameter wafers, the diameter of the opaque disk 12 is approximately 33.02 cm (13 inches).

In order to provide some speed in altering the temperature of the top surface of the wafer, it is advantageous for opaque disk 12 to be of a low-heat-capacity material so that the flux of energy from the opaque disk to the wafer can be altered as quickly as possible. It is also advantageous for this opaque disk to have a high coefficient of thermal conductivity so that the temperature of a bottom surface 118 of the opaque disk will exhibit a smoother temperature distribution than the distribution of energy flux to the top surface of the opaque disk. However, the primary factors in selecting the material for the opaque disk are that this disk be substantially opaque to the light from lamps 115 and be substantially chemically inert to the processes performed within the processing chamber.

Three materials that meet these last two criteria are carbide, carbide-coated graphite and opaque quartz. Carbide and quartz are advantageous because they do not significantly out gas. Graphite is advantageous because it has high thermal conductivity. Graphite also has a high heat capacity which is advantageous in any process in which it is advantageous to avoid temporal variations in the wafer temperature during a given process step. The high heat capacity makes each opaque disk function as a thermal flywheel for temporal variations of energy from lamps 110 and 113. The high thermal conductivity makes each opaque disk function as a thermal flywheel for spatial variations of energy from lamps 110 and 113.

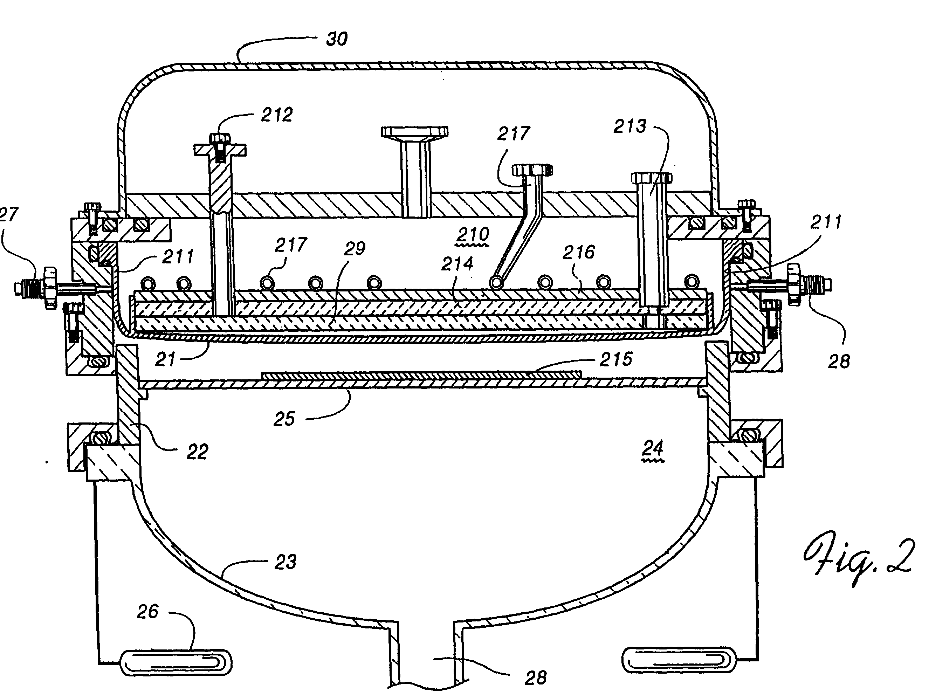

Figure 2 illustrates an alternate embodiment of the reactor in which the disk shaped thermal source is a circular region of a top wall of the processing chamber. In this embodiment, the reactor chamber 24 contains a thin quartz top wall 21, a side wall 22 and a quartz bottom wall 23 that enclose a processing chamber 24. The bottom wall is transparent to a flux of light incident onto a susceptor 25 from a circular array of tungsten-halogen lamps 26. Process gases are supplied into chamber 24 through a gas input port 27 and are removed through a gas exhaust port {not shown in this figure). The pressure in the processing chamber is reduced to on the order of 133 hPa (100 torr) during wafer processing. An additional gas input port 28 is included to enable a purge gas to be supplied into the processing chamber 24. An exhaust port (not shown in this figure) is coupled to a pump to enable a pressure on the order of 133 hPa (100 torr) to be produced in the processing chamber.

The temperature of top wall 21 is controlled by a quartz heater 29. Because of the low conductivity of quartz, it is important to keep the thickness of the top wall small (on the order of 1.59 mm (1/16 inch)) to enable heat to effectively transfer from the heater into the processing chamber. In addition, to keep the top wall in close proximity to the wafer, this wall must be approximately planar. For a reactor designed to process 15.25 cm (6 inch) diameter wafers, processing chamber has a lateral diameter of approximately 30.5 cm (12 inches). Across this 30.5 cm (12 inch) span, wall 21 deviates from planarity only by approximately 1.59 mm (1/16th of an inch.)

Because such a thin, approximately planar wall cannot withstand a substantial pressure difference across the wall, heater 29 is contained within a second vacuum chamber 210 enclosed by a vacuum chamber wall 211. Power is coupled into the heater through an input feed 212 and the temperature of the heater is measured by a thermocouple 213. An insulating layer 214 of opaque quartz on top of the heater facilitates transfer of thermal energy from the heater across wall 21 to a wafer 215 supported on the susceptor.

On top of insulating layer 214 is a cooling arrangement having a conductive plate 216 typically comprised of metallic material such as copper, a planar coil of metallic tubing and fluid feed source 217 through which water is fed to cool plate 216. In this configuration plate 216 operates to cool the heater assembly comprised of the quartz heater 29 overlayed by the opaque insulating layer 214. Operationally, the cooling or heating of plate 216 either enhances or reduces heat conveyed from the heater assembly to the thermal source quartz top wall 21. In this manner the heater and cooling assemblies, in combination with top wall 21, all operate as a thermal flywheel heat distribution source for wafer 215 and function in the same manner as opaque disk 12 of Fig. 1. The apparatus of Fig. 2 is shown with a cover 30 which functions only to cover the fittings and other elements above the second vacuum chamber 210.

The above-described preferred embodiments of the present invention are not intended to limit the scope of the present invention as demonstrated by the claims which follow, as one skilled in the art can, with minimal experimentation, extend the disclosed concepts of the invention to the claimed scope of the invention.

## Claims

1. An apparatus for CVD processing of semiconductor substrates comprising:
a) a light source (113) of sufficient intensity to elevate a substrate to a temperature suitable for processing;
b) a susceptor (110) positioned to receive a substrate (13) and incident light from said source of light;
c) a wall (14, 15, 16) that encloses the processing chamber within which substrates are to be processed, at least a portion (14) of said wall is transparent to enable light from said first source of light to be incident on said susceptor (110); and
d) a thermal source closely spaced from a top surface of the susceptor (110) for providing additional heat to a wafer being processed in order to produce a temperature profile of uniformity across the top surface of the substrate (13)
**characterized** in that
e) a second light source (115) of sufficient intensity is provided to irradiate and heat the thermal source, and
- said thermal source comprises an opaque disk (12) positioned and oriented within to receive light from said light source (115) on the top surface of the disk (12) to elevate its temperature, whereby this opaque disk (12) is heated by light incident on its top surface and transfers a smoothed energy flux from said bottom surface of the opaque disk (12) to said substrate (13).

2. The apparatus of claim 1 characterized in that said thermal source is positioned coaxially with and substantially parallel to said susceptor (110).

3. The apparatus of claim 1 wherein said second source of light (115) elevates the temperature of said opaque disk (12) to a preselected temperature, whereby the temperature of said opaque disk (12) can be selected to improve temperature uniformity in a wafer being processed without producing significant amount of particulates.

4. The apparatus of claim 4 wherein the bottom surface of the opaque disk (12) is spaced from the top surface of said susceptor (110) at a distance to enable effective heat transfer between the disk (12) and any substrate (13) seated on the susceptor (110).

5. The apparatus of claim 4 wherein said distance is in the range of from about 12.7 to 25.4 mm (0.5-1 inches).

6. A reactor as in claim 1 wherein said opaque disk (12) has a compositional recipe selected from the group of materials consisting essentially of carbide, carbide-coated graphite, and opaque quartz.

7. The apparatus of claim 1 wherein said opaque disk (12) has a thickness in the range of from about 0.762 mm - 6.35 mm.

8. The apparatus of claim 1 wherein said opaque disk (12) has a diameter ranging from in excess of the substrate (110) being processed to a dimension substantially equal to the inner diameter of the processing chamber.

9. The apparatus of claim 1 wherein said opaque disk (12) and said substrate (13) are each cylindrical in shape.

10. The apparatus of claim 9 further comprising: means (112) for rotating the substrate about the cylindrical axis of the susceptor (110).

11. An apparatus for CVD processing of semiconductor substrates comprising:
a) a light source (26) of sufficient intensity to elevate a substrate to a temperature suitable for processing;
b) a susceptor (25) positioned to receive a substrate (215) and incident light from said source of light (26);
c) a wall (21, 22, 23) that encloses the processing chamber (24) within which substrates (215) are to be processed, at least a portion of said wall (21, 23) is transparent to enable light from said first source of light (26) to be incident on said susceptor (25); and
d) a thermal source (29) closely spaced from a top surface of the susceptor (25) for providing additional heat to a substrate (215) being processed in order to produce a temperature profile of uniformity across the top surface of the substrate (215);
e) a first vacuum chamber housing the susceptor (25) and the substrate (215);
characterized by
f) a second vacuum chamber (210) housing the thermal source (29) and positioned adjacent the first vacuum chamber so as to maintain coaxial and parallel alignment of the thermal source (29) with the substrate (25); and
g) a thin thermally conductive wall (21) having a thickness on the order of 1.59 mm (1/16 inch) adjacent the thermal source (29) and adjoining the first and second chamber whereby thermal energy is communicated from the thermal source (29) which is a heater assembly comprising a heater element to the substrate surface (215).

12. The apparatus of claim 11 wherein the thermal source comprises a heater assembly composed of (i) a heater element layer (29) and (ii) an insulating layer (214), said heater element layer (29) being located between the top wall (21) and the insulating layer (214).

13. The apparatus of claim 12 further comprising a cooling assembly (216) adjacent the layered heater element(29).

14. The apparatus of claim 13 wherein the cooling assembly (216) is a layered structure in coplanar communication with the heater element (29); said layered cooling assembly (216) being of metallic composition and having tubular fluid cooling means (217).

15. The apparatus of claim 13 wherein the cooling assembly (216) is comprised of a metal plate having tubular fluid cooling coils (217) affixed thereto.

16. The apparatus of claim 13 wherein the tubular fluid cooling means (217) are embedded in the metallic layer (216).

## Patentansprüche

1. Vorrichtung zur CVD-Bearbeitung von Halbleitersubstraten, umfassend:
a) eine Lichtquelle (113) mit ausreichender Intensität, um ein Substrat auf eine Temperatur anzuheben, die sich zur Bearbeitung eignet;
b) eine Heizplatte (110), die zur Aufnahme eines Substrats (13) und zum Empfang von einfallendem Licht von der Lichtquelle angeordnet ist;
c) eine Wand (14, 15, 16), die die Bearbeitungskammer umschließt, innerhalb welcher Substrate bearbeitet werden sollen, wobei zumindest ein Teil (14) der Wand lichtdurchlässig ist, um zu ermöglichen, daß Licht von der ersten Lichtquelle auf die Heizplatte (110) einfällt; und
d) eine Wärmequelle, die von einer oberen Oberfläche der Heizplatte (110) eng beabstandet ist, zum Liefern von zusätzlicher Wärme zu einem Wafer, der bearbeitet wird, um ein gleichmäßiges Temperaturprofil über die obere Oberfläche des Substrats (13) zu erzeugen,
dadurch **gekennzeichnet**, daß
e) eine zweite Lichtquelle (115) mit ausreichender Intensität vorgesehen ist, um die Wärmequelle zu bestrahlen und zu heizen, und
- die Wärmequelle eine lichtundurchlässige Scheibe (12) aufweist, welche darin angeordnet und orientiert ist, um Licht von der Lichtquelle (115) auf der oberen Oberfläche der Scheibe (12) zu empfangen, um ihre Temperatur zu erhöhen, wobei diese lichtundurchlässige Scheibe (12) durch auf ihre obere Oberfläche einfallendes Licht erhitzt wird und einen ausgeglichenen Energiefluß von der unteren Oberfläche der lichtundurchlässigen Scheibe (12) zu dem Substrat (13) überträgt.

2. Vorrichtung nach Anspruch 1, dadurch gekennzeichnet, daß die Wärmequelle koaxial mit und im wesentlichen parallel zu der Heizplatte (110) angeordnet ist.

3. Vorrichtung nach Anspruch 1, wobei die zweite Lichtquelle (115) die Temperatur der lichtundurchlässigen Scheibe (12) auf eine vorgewählte Temperatur erhöht, wobei die Temperatur der lichtundurchlässigen Scheibe (12) so gewählt werden kann, daß die Temperaturgleichmäßigkeit in einem Wafer, welcher bearbeitet wird, verbessert wird, ohne eine signifikante Menge an Makroteilchen zu erzeugen.

4. Vorrichtung nach Anspruch 4 [1], wobei die untere Oberfläche der lichtundurchlässigen Scheibe (12) von der oberen Oberfläche der Heizplatte (110) in einem Abstand angeordnet ist, um zwischen der Scheibe (12) und irgendeinem auf der Heizplatte (110) liegenden Substrat (13) eine wirksame Wärmeübertragung zu ermöglichen.

5. Vorrichtung nach Anspruch 4, wobei der Abstand im Bereich von etwa 12,7 bis 25,4 mm (0,5-1 Inch) liegt.

6. Reaktor nach Anspruch 1, wobei die lichtundurchlässige Scheibe (12) eine Zusammensetzungsrezeptur aufweist, die aus der Gruppe von Materialien ausgewählt ist, welche im wesentlichen aus Carbid, mit Carbid beschichtetem Graphit und lichtundurchlässigem Quarz besteht.

7. Vorrichtung nach Anspruch 1, wobei die lichtundurchlässige Scheibe (12) eine Dicke im Bereich von etwa 0,762 mm - 6,35 mm aufweist.

8. Vorrichtung nach Anspruch 1, wobei die lichtundurchlässige Scheibe (12) einen Durchmesser aufweist, der im Bereich von oberhalb jenem des bearbeiteten Substrats (110) bis zu einer Abmessung, die im wesentlichen gleich dem Innendurchmesser der Bearbeitungskammer ist, liegt.

9. Vorrichtung nach Anspruch 1, wobei die lichtundurchlässige Scheibe (12) und das Substrat (13) jeweils eine zylindrische Form aufweisen.

10. Vorrichtung nach Anspruch 9, welche ferner umfaßt:
ein Mittel (112) zum Drehen des Substrats um die Zylinderachse der Heizplatte (110).

11. Vorrichtung zur CVD-Bearbeitung von Halbleitersubstraten, umfassend:
a) eine Lichtquelle (26) mit ausreichender Intensität, um ein Substrat auf eine Temperatur anzuheben, die sich zur Bearbeitung eignet;
b) eine Heizplatte (25), die zur Aufnahme eines Substrats (215) und zum Empfang von einfallendem Licht von der Lichtquelle (26) angeordnet ist;
c) eine Wand (21, 22, 23), die die Bearbeitungskammer (24) umschließt, innerhalb welcher Substrate (215) bearbeitet werden sollen, wobei zumindest ein Teil der Wand (21, 23) lichtdurchlässig ist, um zu ermöglichen, daß Licht von der ersten Lichtquelle (26) auf die Heizplatte (25) einfällt; und
d) eine Wärmequelle (29), die von einer oberen Oberfläche der Heizplatte (25) eng beabstandet ist, zum Liefern von zusätzlicher Wärme zu einem Substrat (215), welches bearbeitet wird, um ein gleichmäßiges Temperaturprofil über die obere Oberfläche des Substrats (215) zu erzeugen;
e) eine erste Vakuumkammer, in der die Heizplatte (25) und das Substrat (215) untergebracht sind;
gekennzeichnet durch:
f) eine zweite Vakuumkammer (210), in der die Wärmequelle (29) untergebracht ist und die benachbart zur ersten Vakuumkammer angeordnet ist, um eine koaxiale und parallele Ausrichtung der Wärmequelle (29) zum Substrat (25) aufrechtzuerhalten; und
g) eine dünne thermisch leitende Wand (21) mit einer Dicke in der Größenordnung von 1,59 mm (1/16 Inch), welche zur Wärmequelle (29) benachbart ist und an die erste und die zweite Kammer angrenzt, wobei Wärmeenergie von der Wärmequelle (29), welche eine Heizanordnung mit einem Heizelement ist, auf die Substratoberfläche (215) übertragen wird.

12. Vorrichtung nach Anspruch 11, wobei die Wärmequelle eine Heizanordnung aufweist, die aus (i) einer Heizelementschicht (29) und (ii) einer Isolationsschicht (214) besteht, wobei die Heizelementschicht (29) zwischen der oberen Wand (21) und der Isolationsschicht (214) angeordnet ist.

13. Vorrichtung nach Anspruch 12, welche ferner eine Kühlanordnung (216) benachbart zum schichtartigen Heizelement (29) aufweist.

14. Vorrichtung nach Anspruch 13, wobei die Kühlanordnung (216) eine Schichtstruktur in koplanarer Verbindung mit dem Heizelement (29) ist; wobei die schichtartige Kühlanordnung (216) aus einer Metallzusammensetzung besteht und röhrenförmige Fluidkühlvorrichtungen (217) aufweist.

15. Vorrichtung nach Anspruch 13, wobei die Kühlanordnung (216) aus einer Metallplatte mit daran befestigten röhrenförmigen Fluidkühlschlangen (217) besteht.

16. Vorrichtung nach Anspruch 13, wobei die röhrenförmigen Fluidkühlvorrichtungen (217) in die Metallschicht (216) eingebettet sind.

## Revendications

1. Appareil destiné au traitement de dépôt chimique en phase vapeur de substrats de semiconducteurs comprenant :
a) une source de lumière (113) d'intensité suffisante pour élever un substrat à une température convenant à un traitement,
b) un suscepteur (110) positionné de façon à recevoir un substrat (13) et de la lumière incidente provenant de ladite source de lumière,
c) une paroi (14, 15, 16) qui entoure la chambre de traitement à l'intérieur de laquelle des substrats doivent être traités, au moins une partie (14) de ladite paroi est transparente de manière à permettre que la lumière provenant de ladite première source de lumière soit incidente sur ledit suscepteur (110), et
d) une source thermique étroitement espacée d'une surface supérieure du suscepteur (110) destinée à fournir une chaleur supplémentaire à une tranche qui est traitée de manière à produire un profil de température uniforme en travers de la surface supérieure du substrat (13),
caractérisé en ce que
e) une seconde source de lumière (115) d'intensité suffisante est prévue pour faire illuminer et chauffer la source thermique, et
- ladite source thermique comprend un disque opaque (12) positionné et orienté à l'intérieur de façon à recevoir de la lumière de ladite source de lumière (115) sur la surface supérieure du disque (12) afin d'élever sa température, d'où il résulte que ce disque opaque (12) est chauffé par la lumière incidente sur sa surface supérieure et transfère un flux d'énergie lissé depuis ladite surface inférieure du disque opaque (12) vers ledit substrat (13).

2. Appareil selon la revendication 1, caractérisé en ce que ladite source thermique est positionnée de façon coaxiale et d'une manière pratiquement parallèle audit suscepteur (110).

3. Appareil selon la revendication 1, dans lequel ladite seconde source de lumière (115) élève la température dudit disque opaque (12) à une température présélectionnée, d'où il résulte que la température dudit disque opaque (12) peut être sélectionnée pour améliorer l'uniformité de température d'une tranche qui est traitée sans produire de quantité significative de particules.

4. Appareil selon la revendication 4, dans lequel la surface inférieure du disque opaque (12) est espacée de la surface supérieure dudit suscepteur (110) à une distance qui permet un transfert de chaleur efficace entre le disque (12) et tout substrat quelconque (13) reposant sur le suscepteur (110) .

5. Appareil selon la revendication 4, dans lequel ladite distance est dans la plage d'environ 12,7 à 25,4 mm (0,5 à 1 pouce).

6. Réacteur selon la revendication 1, dans lequel ledit disque opaque (12) présente une formule de composition choisie dans le groupe de matériaux constitué essentiellement de carbure, de graphite revêtu de carbure, et de quartz opaque.

7. Appareil selon la revendication 1, dans lequel ledit disque opaque (12) présente une épaisseur dans la plage d'environ 0,762 mm à 6,35 mm.

8. Appareil selon la revendication 1, dans lequel ledit disque opaque (12) présente un diamètre s'étendant depuis un dépassement du substrat (110) qui est traité jusqu'à une dimension pratiquement égale au diamètre intérieur de la chambre de traitement.

9. Appareil selon la revendication 1, dans lequel ledit disque opaque (12) et ledit substrat (13) sont chacun de forme cylindrique.

10. Appareil selon la revendication 9, comprenant en outre :
un moyen (112) destiné à faire tourner le substrat autour de l'axe cylindrique du suscepteur (110).

11. Appareil destiné au traitement de dépôt chimique en phase vapeur de substrats de semiconducteurs comprenant :
a) une source de lumière (26) d'intensité suffisante pour élever un substrat à une température convenant à un traitement,
b) un suscepteur (25) positionné de façon à recevoir un substrat (215) et de la lumière incidente provenant de ladite source de lumière (26),
c) une paroi (21, 22, 23) qui entoure la chambre de traitement (24) à l'intérieur de laquelle des substrats (215) doivent être traités, au moins une partie de ladite paroi (21, 23) est transparente pour permettre que la lumière provenant de ladite première source de lumière (26) soit incidente sur ledit suscepteur (25), et
d) une source thermique (29) étroitement espacée d'une surface supérieure du suscepteur (25) afin de fournir une chaleur supplémentaire à un substrat (215) qui est traité de manière à produire un profil de température uniforme en travers de la surface supérieure du substrat (215),
e) une première chambre à vide logeant le suscepteur (25) et le substrat (215),
caractérisé par
f) une seconde chambre à vide (210) logeant la source thermique (29) et positionnée de façon contiguë à la première chambre à vide de manière à maintenir un alignement coaxial et parallèle de la source thermique (29) et du substrat (25), et
g) une paroi mince thermiquement conductrice (21) présentant une épaisseur de l'ordre de 1,59 mm (1/16 pouce) contiguë à la source thermique (29) et rejoignant la première et la seconde chambres d'où il résulte que de l'énergie thermique est communiquée depuis la source thermique (29), qui est un ensemble de dispositif de chauffage comprenant un élément de chauffage, vers la surface du substrat (215).

12. Appareil selon la revendication 11, dans lequel la source thermique comprend un ensemble de dispositif de chauffage constitué de (i) une couche d'élément de chauffage (29) et (ii) une couche isolante (214), ladite couche d'élément de chauffage (29) étant située entre la paroi supérieure (21) et la couche isolante (214).

13. Appareil selon la revendication 12, comprenant en outre un ensemble de refroidissement (216) contigu à l'élément de dispositif de chauffage en couche (29).

14. Appareil selon la revendication 13, dans lequel l'ensemble de refroidissement (216) est une structure en couche en communication coplanaire avec l'élément de chauffage (29), ledit ensemble de refroidissement en couche (216) étant de composition métallique et comportant un moyen de refroidissement tubulaire à fluide (217).

15. Appareil selon la revendication 13, dans lequel l'ensemble de refroidissement (216) est constitué d'une plaque métallique comportant des serpentins de refroidissement tubulaires à fluide (217) fixés à celle-ci.

16. Appareil selon la revendication 13, dans lequel le moyen de refroidissement tubulaire à fluide (217) est incorporé dans la couche métallique (216).
